# EUROPÄISCHE PATENTANMELDUNG

(11) **EP 1 845 564 A2**
(43) Veröffentlichungstag der Anmeldung: **17.10.2007**
(21) Anmeldenummer: 07005723.7
(22) Anmeldetag: 20.03.2007
(51) Int. Cl.: H01L 33/00

(54) **Strahlungsemittierender Körper und Verfahren zur Herstellung eines strahlungsemittierenden Körpers**

(30) Priorität: 13.04.2006 DE 102006017556; 17.01.2007 DE 102007002416
(71) Anmelder: Osram Opto Semiconductors GmbH, 93049 Regensburg (DE)
(72) Erfinder: Windisch, Reiner, Dr., 93186 Pettendorf (DE); Hahn, Berthold, Dr., 93155 Hemau (DE); Härle, Volker, Dr., 93164 Laaber (DE)
(74) Vertreter: Epping - Hermann - Fischer

(57) **Zusammenfassung**

Die Erfindung betrifft einen strahlungsemittierenden Körper, der
-eine Schichtenfolge, die einen aktiven Bereich zur Erzeugung von elektromagnetischer Strahlung aufweist,
- eine auf einer ersten Seite der Schichtenfolge angeordnete Auskoppelschicht zur Auskopplung der erzeugten Strahlung,
- eine auf einer der ersten Seite gegenüberliegenden zweiten Seite angeordnete Reflexionsschicht zur Reflexion der erzeugten Strahlung und
- eine der Reflexionsschicht zugewandte Grenzfläche der Schichtenfolge, die eine laterale Strukturierung mit hervorstehenden Strukturelementen aufweist, umfasst, wobei die Reflexionsschicht derart mit der Schichtenfolge verbunden ist, dass die Reflexionsschicht eine der Strukturierung der Grenzfläche entsprechende Strukturierung aufweist. Ferner wird ein Verfahren zur Herstellung eines strahlungsemittierenden Körpers angegeben.

## Beschreibung

Die Erfindung betrifft einen strahlungsemittierenden Körper, der eine Schichtenfolge mit einem aktiven Bereich zur Erzeugung von Strahlung, eine Auskoppelschicht und eine Reflexionsschicht zur Reflexion der erzeugten Strahlung aufweist. Ferner betrifft die Erfindung ein Verfahren zur Herstellung eines derartigen strahlungsemittierenden Körpers.

Diese Patentanmeldung beansprucht die Priorität der deutschen Patentanmeldung 102006017556.5 und der deutschen Patentanmeldung 102007002416.0, deren Offenbarungsgehalt hiermit durch Rückbezug aufgenommen wird.

Bei einem strahlungsemittierenden Körper, der ein optisch dichtes Material enthält, kann am Übergang zu einem optisch dünnen Medium vom Körper erzeugte Strahlung totalreflektiert und in den Körper zurückreflektiert werden. Die Strahlung wird im strahlungsemittierenden Körper "gefangen", wodurch weniger Strahlung nach außen dringt.

In der Patentschrift US 3 739 217 ist ein strahlungsemittierendes Bauelement mit einem strahlungsemittierenden Körper beschrieben, der eine unebene Oberfläche zur Verbesserung der Strahlungsauskopplung aufweist. Von dem Körper erzeugte Strahlung, die an einer der unebenen Oberfläche gegenüber liegenden Strahlungsauskoppelfläche totalreflektiert wird, wird in Richtung der unebenen Oberfläche umgelenkt. Dort wird die Strahlung derart reflektiert, dass sie durch die Strahlungsauskoppelfläche hindurch aus dem Körper austreten kann. Der Körper ist auf der Seite, auf der sich die unebene Oberfläche befindet, auf eine tragende, reflektierende Grundplatte aufgebracht.

Es ist Aufgabe der vorliegenden Erfindung, einen strahlungsemittierenden Körper mit einer besonders effizienten Strahlungsauskopplung anzugeben. Diese Aufgabe wird durch einen strahlungsemittierenden Körper gemäß Patentanspruch 1 gelöst.

Ferner ist es Aufgabe der vorliegenden Erfindung, ein Herstellungsverfahren für einen strahlungsemittierenden Körper mit einer besonders effizienten Strahlungsauskopplung anzugeben. Diese Aufgabe wird durch ein Verfahren gemäß Patentanspruch 27 gelöst.

Der strahlungsemittierende Körper umfasst eine Schichtenfolge, die einen aktiven Bereich zur Erzeugung von elektromagnetischer Strahlung aufweist, umfasst eine auf einer ersten Seite der Schichtenfolge angeordnete Auskoppelschicht zur Auskopplung der erzeugten Strahlung, umfasst eine auf einer der ersten Seite gegenüberliegenden zweiten Seite angeordnete Reflexionsschicht zur Reflexion der erzeugten Strahlung und eine der Reflexionsschicht zugewandte Grenzfläche der Schichtenfolge, die eine laterale Strukturierung mit einer Mehrzahl von hervorstehenden Strukturelementen aufweist, wobei die Reflexionsschicht derart mit der Schichtenfolge verbunden ist, dass die Reflexionsschicht eine der Strukturierung der Grenzfläche entsprechende Strukturierung aufweist.

Eine Schichtenfolge, die an der Grenzfläche hervorstehende Strukturelemente aufweist, kann vorteilhafterweise eine Steigerung der Strahlungsauskopplung um 25% bis über 200% bewirken. Typischerweise wird die strukturierte Grenzfläche auf der Seite der Auskoppelschicht angeordnet. Dies kann jedoch beispielsweise den Nachteil haben, dass auf der Auskoppelschicht angeordnete Vergussmaterialien vergleichsweise schlecht haften. Die erfindungsgemäße Anordnung der strukturierten Grenzfläche auf der der Auskoppelschicht gegenüber liegenden Seite hat demgegenüber den Vorteil, dass die Auskoppelschicht eben ausgebildet werden kann und dadurch eine verbesserte Haftung von Vergussmaterialien bei gleichzeitiger Steigerung der Strahlungsauskopplung erzielbar ist.

Strahlung, die im aktiven Bereich erzeugt wird und zur strukturierten Grenzfläche gelangt, kann vorteilhafterweise durch diese in einen Winkelbereich abgelenkt werden, der von Totalreflexionen an der Auskoppelschicht ausgenommen ist. Durch die Reflexionsschicht, die eine der Strukturierung der Grenzfläche entsprechende Strukturierung aufweist, kann die Richtung der Strahlung umgekehrt werden. Vorzugsweise wird die Strahlung in Richtung der Auskoppelschicht umgelenkt.

Vorliegend ist unter einer der Grenzfläche entsprechenden Strukturierung zu verstehen, dass eine der Schichtenfolge zugewandte Oberfläche der Reflexionsschicht zu den Strukturelementen der Grenzfläche inverse Strukturelemente aufweist. Die Strukturelemente können insbesondere dadurch ausgebildet werden, dass die Reflexionsschicht auf die Schichtenfolge formschlüssig aufgebracht wird.

Der erfindungsgemäße Verbund aus einer Auskoppelschicht, einer Schichtenfolge und einer mit der strukturierten Grenzfläche verbundenen entsprechend strukturierten Reflexionsschicht ermöglicht vorteilhafterweise eine lokale Trennung zweier funktioneller Bereiche, von denen der eine für die Strahlungsauskopplung (Auskoppelschicht) und der andere für die Steigerung der Strahlungsauskopplung (Reflexionsschicht in Kombination mit Strukturelementen) vorgesehen ist.

Gemäß einer bevorzugten Ausführungsform umfasst die Schichtenfolge des strahlungsemittierenden Körpers eine Halbleiter-Schichtenfolge. Diese wiederum umfasst den aktiven Bereich mit einem p-n-Übergang. Beispielsweise kann der aktive Bereich eine Quantentopfstruktur aufweisen, wobei die Quantentopfstruktur jegliche Struktur bezeichnet, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u. a. Quantentröge, Quantendrähte und Quantenpunkte und jede Kombination dieser Strukturen.

Vorzugsweise enthält die Schichtenfolge ein auf Phosphid- oder Nitrid-basierendes Verbindungshalbleitermaterial. Diese Materialien sind zur Erzeugung von Strahlung einer Wellenlänge hauptsächlich im blauen bis infraroten Bereich des optischen Spektrums geeignet.

"Auf Phosphid-basierendes Verbindungshalbleitermaterial" bedeutet in diesem Zusammenhang, dass das Material vorzugsweise AlₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Entsprechend bedeutet "auf Nitrid-basierendes Verbindungshalbleitermaterial", dass das Material ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Vorzugsweise ist der strahlungsemittierende Körper ein Dünnfilm-Halbleiterkörper, der sich insbesondere durch mindestens eines der folgenden charakteristischen Merkmale auszeichnet:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein strahlungsemittierender Dünnfilm-Halbleiterkörper ist in guter Näherung ein Lambert'scher Oberflächenstrahler und eignet sich besonders gut für Hinterleuchtungs-, Beleuchtungs- beziehungsweise Anzeigezwecke.

Die Strukturelemente sind besonders wirksam, wenn sie wahlweise eine Strukturgröße aufweisen, die entweder im Bereich der Wellenlänge der auf die Strukturelemente auftreffenden Strahlung liegt oder größer ist als diese. Hierbei liegt die Strukturgröße im Bereich der Wellenlänge, wenn sie gleich groß oder größer ist als die halbe Wellenlänge und kleiner oder gleich groß ist wie die doppelte Wellenlänge. Alternativ kann die Strukturgröße in dem Maße größer als die Wellenlänge sein, dass die Gesetze der geometrischen Optik gelten. Nach oben ist die Strukturgröße dann lediglich durch die Größe des strahlungsemittierenden Körpers und die Dicke der strukturierten Schicht begrenzt.

Vorliegend ist unter der "Strukturgröße" vorzugsweise mindestens eine der Größen "Strukturbreite" oder "Strukturtiefe" zu verstehen. Als "Strukturbreite" wird die Breite des Strukturelements, gemessen in lateraler Richtung, und als "Strukturtiefe" die Tiefe des Strukturelements, gemessen in vertikaler Richtung, bezeichnet.

Sind zumindest in Teilen Strukturelemente mit unterschiedlichen Strukturgrößen vorhanden, so liegt die Strukturgröße sowohl im Mittel als auch maximal und minimal im Bereich der Wellenlänge beziehungsweise ist größer als diese.

Die Reflexionsschicht enthält vorzugsweise ein Metall oder ist als metallische Schicht ausgebildet. Vorteilhafterweise kann dadurch der strahlungsemittierende Körper mittels der Reflexionsschicht elektrisch angeschlossen werden. Zweckmäßigerweise wird ein Metall verwendet, das zur Reflexion der auftreffenden Strahlung besonders geeignet ist. Beispielsweise ist bei einem auf Phosphor-basierenden Verbindungshalbleitermaterial eine Reflexionsschicht, die Au oder Ag enthält, und bei einem auf Nitrid-basierenden Verbindungshalbleitermaterial eine Reflexionsschicht, die Ag oder Al enthält, besonders geeignet.

Bevorzugterweise ist die Reflexionsschicht unmittelbar auf die Schichtenfolge aufgebracht. Somit ist die Reflexionsschicht nicht selbsttragend. Beispielsweise kann die Reflexionsschicht auf die Schichtenfolge aufgedampft oder aufgesputtert sein. Dies ermöglicht eine innige Verbindung der Reflexionsschicht mit der Schichtenfolge. Besonders bevorzugt ist die Reflexionsschicht mit der Schichtenfolge formschlüssig verbunden.

Gemäß einer bevorzugten Variante weist die Schichtenfolge eine Zwischenschicht auf, die zwischen der Halbleiter-Schichtenfolge und der Reflexionsschicht angeordnet ist.

Die Zwischenschicht ist vorzugsweise für die vom aktiven Bereich erzeugte Strahlung durchlässig. Somit kann die auf die Zwischenschicht auftreffende Strahlung die Zwischenschicht durchqueren und an der Reflexionsschicht reflektiert werden.

Ferner kann die Zwischenschicht wahlweise elektrisch nicht leitend oder elektrisch leitend ausgebildet sein. Dabei ist für eine elektrisch nicht leitende Zwischenschicht ein dielektrisches Material, insbesondere SiN oder SiO₂, und für eine elektrisch leitende Zwischenschicht ein Oxid, insbesondere ITO (Indium Tin Oxide) oder ZnO, besonders geeignet. Vorteilhafterweise kann bei einer elektrisch leitenden Zwischenschicht die Reflexionsschicht als rückseitiger elektrischer Kontakt des strahlungsemittierenden Körpers dienen.

Gemäß einer ersten Variante ist eine an die Zwischenschicht angrenzende Oberfläche der Halbleiter-Schichtenfolge eben ausgebildet.

In diesem Fall weist die Grenzfläche der Schichtenfolge eine laterale Strukturierung mit einer Mehrzahl von hervorstehenden Strukturelementen insbesondere dadurch auf, dass eine an die Reflexionsschicht angrenzende Oberfläche der Zwischenschicht strukturiert ist.

Insbesondere ist die Grenzfläche der Schichtenfolge aufgeraut. Dabei können die Strukturelemente zumindest in Teilen unterschiedliche Strukturgrößen aufweisen. Desweiteren können die Strukturelemente unregelmäßig auf der Grenzfläche verteilt sein. Bei einer Schichtenfolge, die keine Zwischenschicht aufweist, ist hierbei die Oberfläche der Halbleiter-Schichtenfolge aufgeraut, ansonsten ist die Oberfläche der Zwischenschicht aufgeraut.

Ferner kann zur Erzielung einer lateralen Strukturierung mit einer Mehrzahl von hervorstehenden Strukturelementen auf der Grenzfläche eine an die Zwischenschicht angrenzende Oberfläche der Halbleiter-Schichtenfolge eine Mehrzahl von Strukturelementen aufweisen. Da die Zwischenschicht vorzugsweise auf der Oberfläche der Halbleiter-Schichtenfolge aufgebracht ist, verleiht die Oberfläche der Zwischenschicht in Folge ihre Form.

Gemäß einer weiteren Ausführungsform des strahlungsemittierenden Körpers ist zwischen dem aktiven Bereich und der Reflexionsschicht ein Tunnelübergang angeordnet.

Der Tunnelübergang kann gemäß einer ersten Variante in der Halbleiter-Schichtenfolge integriert sein und bevorzugt zwei, vorzugsweise hochdotierte, Tunnelschichten unterschiedlichen Leitungstyps umfassen. Besonders bevorzugt grenzt eine der Tunnelschichten unmittelbar an die Reflexionsschicht an.

Gemäß einer zweiten Variante ist der Tunnelübergang zwischen der Zwischenschicht als einer ersten Tunnelschicht und einer an die Zwischenschicht angrenzenden Schicht der Halbleiter-Schichtenfolge als einer zweiten Tunnelschicht ausgebildet.

Über den Tunnelübergang kann der strahlungsemittierende Körper mit vorteilhaft geringem Widerstand elektrisch versorgt werden. Im Gegensatz zu einem Halbleiterkörper mit einer Mehrzahl von aktiven Bereichen, bei dem ein Tunnelübergang zwischen zwei aktiven Bereichen angeordnet ist, dient der Tunnelübergang vorliegend der elektrisch leitenden Verbindung der Reflexionsschicht zum aktiven Bereich und nicht der elektrischen Ankopplung verschiedener aktiver Bereiche aneinander.

Gemäß einer bevorzugten Ausführungsform ist auf der Auskoppelschicht eine für die erzeugte Strahlung durchlässige Fensterschicht angeordnet. Bevorzugter Weise ist die Fensterschicht elektrisch leitend und enthält insbesondere ein Material wie ITO oder ZnO. Diese Schicht kann dann als vorderseitiger elektrischer Kontakt des strahlungsemittierenden Körpers dienen. Besonders bevorzugt ist die Fensterschicht auf einer der Auskoppelschicht abgewandten Seite eben ausgebildet.

Besonders geeignet ist eine Fensterschicht, die ein Material enthält, dessen Brechungsindex kleiner ist als der des Materials der Auskoppelschicht beziehungsweise der Schichtenfolge und größer als der eines angrenzenden Mediums, beispielsweise Luft. Dadurch kann das Auftreten von Totalreflexionen reduziert und somit die Strahlungsauskopplung erhöht werden.

Vorzugsweise bildet die Auskoppelschicht einen Teil der Halbleiter-Schichtenfolge. Vorteilhafterweise kann eine Strukturierung der Auskoppelschicht mittels geeigneter Bearbeitung der Schichtenfolge ausgebildet werden.

Gemäß einer weiter bevorzugten Ausführung weist die Auskoppelschicht ebenfalls eine laterale Strukturierung auf.

Gemäß einer ersten Variante ist die Auskoppelschicht aufgeraut. Die Strukturierung kann wie die Ausbildung der Strukturelemente ausgeführt werden.

Gemäß einer zweiten Variante ist die Auskoppelschicht ein photonischer Kristall. Vorteilhafterweise kann mittels des photonischen Kristalls der ursprüngliche Abstrahlwinkel der von dem strahlungsemittierenden Körper erzeugten Strahlung eingeengt und dadurch eine Richtwirkung erzielt werden.

Vorzugsweise umfasst der photonische Kristall eine Mehrzahl von ersten Bereichen mit einem ersten Brechungsindex und eine Mehrzahl von zweiten Bereichen mit einem zweiten Brechungsindex. Besonders bevorzugt sind die Bereiche regelmäßig angeordnet. Die regelmäßige Anordnung kann einem eindimensionalen, zweidimensionalen oder dreidimensionalen Gitter entsprechen. Insbesondere kann der photonische Kristall im Rahmen der Erfindung die Struktur eines zweidimensionalen Gitters aufweisen. Dabei entspricht der Abstand zwischen zwei benachbarten ersten Bereichen beziehungsweise zwei benachbarten zweiten Bereichen der Gitterkonstante. Der photonische Kristall erzielt seine Wirkung am besten, wenn die Gitterkonstante an eine Wellenlänge der von dem strahlungsemittierenden Körper erzeugten Strahlung angepasst ist. Vorzugsweise entspricht der Abstand zwischen zwei benachbarten ersten Bereichen beziehungsweise zwei benachbarten zweiten Bereichen ungefähr der Wellenlänge der von dem strahlungsemittierenden Körper erzeugten Strahlung. Besonders bevorzugt liegt der Abstand zwischen 10⁻⁹ m und 10⁻⁶ m.

Gemäß einer bevorzugten Variante sind die zweiten Bereiche zusammenhängend. Das heißt, dass jeweils zwei zweite Bereiche insbesondere mehr als einen Berührungspunkt, beispielsweise eine Berührungsfläche, aufweisen. Der Berührungspunkt beziehungsweise die Berührungsfläche sind hierbei nicht als physikalische Bestandteile zu verstehen, sondern ergeben sich aufgrund einer gedachten Unterteilung des photonischen Kristalls in gleich aufgebaute "Kristallzellen".

Typischerweise enthält der photonische Kristall ein dielektrisches Material. Gemäß der Erfindung sind die ersten Bereiche besonders bevorzugt gefüllte oder ungefüllte Vertiefungen in einer Halbleiterschicht der Halbleiter-Schichtenfolge. Die ersten Bereiche können als Vertiefungen in periodischer Anordnung in die Halbleiterschicht eingebracht sein. Alternativ ist es möglich, die ersten Bereiche gitterartig anzuordnen, wobei diese inselartig ausgebildet und durch geeignete Zwischenräume, beispielsweise eine zusammenhängende Vertiefung, voneinander getrennt sind. Die zweite Möglichkeit stellt somit die Inversion der ersten Möglichkeit dar, indem die Bereiche und die Vertiefungen gegeneinander vertauscht sind. In beiden Fällen können vorteilhafterweise die Vertiefungen beziehungsweise Zwischenräume mit einem Füllmaterial, beispielsweise einem Dielektrikum oder einem anderen Halbleitermaterial, gefüllt sein, dessen Brechungsindex sich von dem Brechungsindex des ersten Bereichs unterscheidet. Insbesondere weisen die ersten Bereiche eine Breite und/oder Tiefe zwischen 100nm und 500nm auf.

Im Folgenden wird ein Verfahren zur Herstellung eines strahlungsemittierenden Körpers angegeben. Insbesondere ist das Verfahren dazu geeignet, einen strahlungsemittierenden Körper gemäß den oben genannten Ausgestaltungen herzustellen.

Es sei darauf hingewiesen, dass das Verfahren außer durch die nachfolgend genannten Merkmalen durch die Merkmale, die im Zusammenhang mit dem strahlungsemittierenden Körper genannt wurden, charakterisiert sein kann und umgekehrt. Dies kann beispielsweise Materialangaben oder Größenangaben betreffen.

Das Verfahren zur Herstellung eines strahlungsemittierenden Körpers weist folgende Schritte auf:
- Ausbilden einer Schichtenfolge umfassend einen aktiven Bereich zur Erzeugung von Strahlung auf einem Substrat,
- Ausbilden einer lateralen Strukturierung mit einer Mehrzahl von hervorstehenden Strukturelementen auf einer Grenzfläche der Schichtenfolge,
- Anordnen einer Reflexionsschicht zur Reflexion der erzeugten Strahlung auf der die Strukturelemente aufweisenden Grenzfläche, so dass die Reflexionsschicht eine der Strukturierung der Grenzfläche entsprechende Strukturierung aufweist.

Gemäß einer bevorzugten Ausgestaltung umfasst die Schichtenfolge eine Halbleiter-Schichtenfolge. Die Halbleiter-Schichtenfolge kann mit Vorteil epitaktisch auf dem Substrat aufgewachsen werden. Ein für das Substrat verwendetes Materialsystem weist besonders bevorzugt eine Gitterkonstante auf, die an die Gitterkonstante des Materialsystems der Schichtenfolge angepasst ist.

Weiter bevorzugt wird das Substrat im Laufe der Herstellung des Körpers abgelöst. Dies hat beispielsweise den Vorteil, dass der strahlungsemittierende Körper mit geringer Höhe hergestellt werden kann. Die Schichtenfolge kann dabei hilfsweise auf einen Zwischenträger aufgebracht werden, der die Schichtenfolge nach dem Ablösen des Substrats stabilisiert. Am Ende kann auch der Zwischenträger abgelöst werden, wobei vorzugsweise an der Stelle des abgelösten Substrats ein Träger angeordnet wird.

Gemäß einer weiteren Ausführungsform des Verfahrens wird eine Oberfläche der Schichtenfolge oder der Halbleiter-Schichtenfolge aufgeraut. Dadurch werden hervorstehende Strukturelemente ausgebildet, die auf der Grenzfläche unregelmäßig angeordnet sind.

Vorzugsweise wird die Grenzfläche mittels natürlicher Lithographie strukturiert.

Dieses Verfahren kann im Wesentlichen dadurch beschrieben werden, dass auf der Grenzfläche der Schichtenfolge Kugeln aufgebracht werden und der Grenzfläche anhaften. Mittels Trockenätzen bleiben an den Orten der Kugeln säulenförmige Strukturelemente stehen, wobei der Raum zwischen den Strukturelementen durch den Trockenätzprozeß von der Schichtenfolge weggeätzt wird.

Auf diese Weise können Strukturelemente mit einer Strukturgröße im Bereich der Wellenlänge der auf die Strukturelemente auftreffenden Strahlung ausgebildet werden. Beispielsweise kann die Strukturbreite 300 nm und die Strukturtiefe 200 nm betragen.

Strukturelemente mit einer Strukturgröße, die wesentlich größer ist als die Wellenlänge, können mittels nasschemischem Ätzen oder Trockenätzen ausgebildet werden. Hierbei liegt die Strukturgröße im Bereich von >4µm.

Ferner können zur Ausbildung von Strukturelementen auf der Grenzfläche beziehungsweise zur Aufrauung der Grenzfläche bekannte Ätzverfahren eingesetzt werden. Derartige Ätzverfahren sind beispielsweise nasschemisches Ätzen oder Trockenätzen, darunter zu nennen reaktives Ionenätzen, Ionenstrahlätzen oder chemisch unterstütztes Ionenstrahlätzen.

Zur Ausbildung von regelmäßigen Grenzflächenstrukturen ist die Photolithographie besonders geeignet.

Vorzugsweise wird die Reflexionsschicht unmittelbar auf die Grenzfläche aufgebracht. Insbesondere wird die Reflexionsschicht derart aufgebracht, dass sie mit der Grenzfläche innig verbunden ist, so dass die Gefahr einer Ablösung der Reflexionsschicht auch bei einem späteren Betrieb des strahlungsemittierenden Körpers vergleichsweise gering ist.

Geeignete Verfahren zum Aufbringen der Reflexionsschicht sind beispielsweise Aufsputtern oder Aufdampfen. Denkbar ist auch, die Reflexionsschicht galvanisch aufzubringen.

Zwischen der Halbleiter-Schichtenfolge und der Reflexionsschicht kann eine Zwischenschicht ausgebildet werden. Die Zwischenschicht kann insbesondere durch Aufsputtern oder mittels CVD (Chemical Vapour Deposition) auf die Halbleiter-Schichtenfolge aufgebracht werden.

Schließlich ist es möglich, eine weitere Oberfläche des strahlungsemittierenden Körpers, die zur Auskopplung der Strahlung dient, ebenfalls nach einem der oben genannten Verfahren mit einer lateralen Strukturierung zu versehen.

Weitere Merkmale, Vorteile und Weiterbildungen der Erfindung ergeben sich aus den nachfolgend in Verbindung mit den Figuren 1 bis 7 erläuterten Ausführungsbeispielen.

Es zeigen:
Figur 1 eine schematische Querschnittsansicht eines ersten Ausführungsbeispiels eines erfindungsgemäßen strahlungsemittierenden Körpers,
Figur 2 eine schematische Querschnittsansicht eines zweiten Ausführungsbeispiels eines erfindungsgemäßen strahlungsemittierenden Körpers,
Figur 3 eine schematische Querschnittsansicht eines dritten Ausführungsbeispiels eines erfindungsgemäßen strahlungsemittierenden Körpers,
Figur 4 eine schematische Querschnittsansicht eines vierten Ausführungsbeispiels eines erfindungsgemäßen strahlungsemittierenden Körpers,
Figur 5 eine schematische Querschnittsansicht eines fünften Ausführungsbeispiels eines erfindungsgemäßen strahlungsemittierenden Körpers,
Figur 6 eine schematische Querschnittsansicht eines sechsten Ausführungsbeispiels eines erfindungsgemäßen strahlungsemittierenden Körpers,
Figuren 7a bis 7f eine schematische Darstellung einzelner Herstellungsschritte eines erfindungsgemäßen Verfahrens.

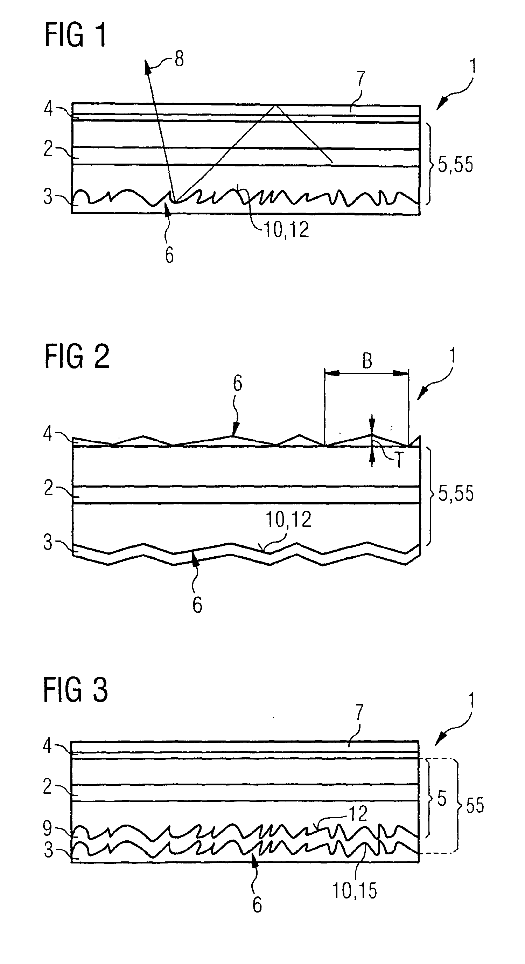

Der in Figur 1 schematisch dargestellte strahlungsemittierende Körper 1 weist eine Schichtenfolge 55 auf, die aus einer Halbleiter-Schichtenfolge 5 besteht, die einen aktiven Bereich 2 zur Erzeugung von elektromagnetischer Strahlung umfasst. Der aktive Bereich 2 enthält besonders bevorzugt ein Halbleitermaterial, insbesondere InGaAlP.

Auf einer ersten Seite der Schichtenfolge 55 ist eine Auskoppelschicht 4 zur Auskopplung der erzeugten Strahlung angeordnet. Diese ist eben ausgebildet und erleichtert somit das Aufbringen einer gut haftenden weiteren Schicht 7. Die Auskoppelschicht 4 kann als ein Teil der Schichtenfolge 5 ausgebildet sein.

Die Vermeidung von Unebenheiten auf der Auskoppelschicht 4 kann die Dichtigkeit von nachgeordneten Schichten, beispielsweise von nachgeordneten Passivierungsschichten, verbessern, was ferner die Zuverlässigkeit und Alterungsbeständigkeit des strahlungsemittierenden Körpers 1 verbessern kann.

Desweiteren erleichtern eine im Gegensatz zu einer aufgerauten Auskoppelschicht vorhandene hohe Qualität und Reinheit der Auskoppelschicht 4 das Aufbringen einer Fensterschicht 7. Insbesondere ist die Fensterschicht 7 strahlungsdurchlässig und elektrisch leitend. Beispielsweise enthält die Fensterschicht 7 ein TCO (Transparent Conductive Oxide), beispielsweise ITO oder ZnO. Die Fensterschicht 7 kann mit Vorteil auf eine p-leitende Schicht des strahlungsemittierenden Halbleiterkörpers 1 aufgebracht werden. Vorzugsweise ist dies die Auskoppelschicht 4.

Mittels der auskoppelseitigen großflächigen Kontaktierung durch die elektrisch leitende Fensterschicht 7 kann eine vergleichsweise gute Stromaufweitung bis in den Hochstrombereich erzielt werden.

Auf einer der ersten Seite gegenüberliegenden zweiten Seite ist eine Reflexionsschicht 3 zur Reflexion der erzeugten Strahlung angeordnet. Die Reflexionsschicht 3 ist eine metallische Schicht, wobei Au oder Ag bei einem InGaA1P aufweisenden strahlungsemittierenden Körper 1 besonders geeignet ist.

Die Dicke der Reflexionsschicht 3 wird so gewählt, dass die auftreffende Strahlung die Reflexionsschicht 3 nicht durchstrahlt. Vorzugsweise liegt die Dicke im Bereich von 1 µm. Da die Reflexionsschicht 3 ein Metall enthält, ist sie zugleich elektrisch leitend, wodurch vorteilhafterweise ein elektrischer Anschluss des strahlungsemittierenden Körpers 1 mittels der Reflexionsschicht 3 möglich ist.

Die der Reflexionsschicht 3 zugewandte Grenzfläche 10, die zugleich eine Oberfläche 12 der Halbleiter-Schichtenfolge 5 ist, weist hervorstehende Strukturelemente 6 auf. Die Strukturgröße der Strukturelemente 6 liegt im Bereich der Wellenlänge der im strahlungsemittierenden Körper 1 erzeugten Strahlung. Sie beträgt insbesondere zwischen 200 nm und 300 nm.

Bei einer derartigen Strukturgröße beruht die an den Strukturelementen auftretende Lichtablenkung (s. Lichtstrahl 8) auf der Streuung der auftreffenden Lichtstrahlen.

Durch die auftretende Streuung kann vorteilhafterweise eine Steigerung der Lichtauskopplung bewirkt werden. Diese Steigerung ist bei einem auf InGaAlP-basierenden Halbleiterkörper besonders erwünscht, da dieser einen die erzeugte Strahlung stark absorbierenden aktiven Bereich 2 aufweist.

Die Strukturelemente 6 sind auf der Grenzfläche 10 zufällig angeordnet und weisen eine Strukturgröße auf, die sowohl im Mittel als auch maximal und minimal im Bereich der Wellenlänge der auftreffenden Strahlung liegt.

Die Strukturelemente 6 können mittels der bereits beschriebenen Verfahren, vorzugsweise mittels natürlicher Lithographie, ausgebildet werden.

Die Reflexionsschicht 3 weist auf einer der Grenzfläche 10 zugewandten Oberfläche zu den Strukturelementen 6 inverse Elemente auf. Diese werden ausgebildet, indem die Reflexionsschicht 3 mit der Halbleiter-Schichtenfolge 5 formschlüssig verbunden wird. Die an der Reflexionsschicht 3 auftretende Richtungsumkehr der auftreffenden Strahlung 8 kann sowohl auf Streuung als auch auf Reflexion beruhen.

Vorteilhafterweise können durch die Reflexionsschicht 3 die Strukturelemente 6 auf die der Auskoppelschicht 4 gegenüberliegende Seite der Schichtenfolge 55 verlagert werden, wodurch bei gleichzeitiger Steigerung der Strahlungsauskopplung die Auskoppelschicht 4 in efffizienter Weise elektrisch kontaktierbar ist.

Der in Figur 2 dargestellte strahlungsemittierende Körper 1 weist die Schichtenfolge 55 umfassend die Halbleiter-Schichtenfolge mit dem aktiven Bereich 2 auf. Vorzugsweise sind die Halbleiter-Schichtenfolge 5 und die Auskoppelschicht 4 epitaktisch gewachsen, wobei das Substrat abgelöst ist. Besonders bevorzugt ist der strahlungsemittierende Körper 1 ein Dünnfilm-Halbleiterkörper.

Die Halbleiter-Schichtenfolge 5 und die Auskoppelschicht 4 enthalten ein auf Nitrid-basierendes Verbindungshalbleitermaterial. Die Halbleiter-Schichtenfolge 5 enthält insbesondere InGaN.

Im Gegensatz zu einem wie in Figur 1 dargestellten, auf InGaAlP-basierenden aktiven Bereich, der die erzeugte Strahlung stark absorbiert, ist der auf InGaN-basierende aktive Bereich bei entsprechender Dicke der Schichtenfolge für die erzeugte Strahlung im Wesentlichen durchlässig.

Somit kann die durch die Strukturelemente 6 bewirkte Steigerung der Strahlungsauskopplung geringer ausfallen als bei dem in Figur 1 dargestellten strahlungsemittierenden Körper 1 und dennoch eine ausreichende Strahlungsauskopplung erzielt werden.

Eine geringere Steigerung der Strahlungsauskopplung tritt beispielsweise auf, wenn die Strukturelemente 6 größer ausgebildet werden. Eine Schicht mit größeren Strukturelementen 6 hat aber den Vorteil, dass die Haftung einer nachgeordneten Schicht weniger beeinträchtigt ist als bei einer stark strukturierten Schicht.

Um dennoch eine ausreichende Strahlungsauskopplung zu erreichen, können, wie in Figur 2 dargestellt, sowohl auf der Auskoppelschicht 4 als auch auf der Schichtenfolge 5 Strukturelemente 6 angeordnet sein.

Die Strukturgröße der Strukturelemente 6 ist in dem Maße größer als die Wellenlänge der auftreffenden Strahlung, dass die Gesetze der geometrischen Optik gelten. Die Strukturgröße betrifft die Breite B und die Tiefe T der Strukturelemente 6. Beispielsweise kann die Strukturgröße im Bereich von >4 µm liegen.

Derartige Strukturelemente 6 können mittels eines der bereits genannten Verfahren ausgebildet werden. Vorzugsweise sind die Strukturelemente 6 unterschiedlich groß und unregelmäßig auf der Grenzfläche 10, die zugleich eine Oberfläche 12 der Halbleiter-Schichtenfolge 5 ist, verteilt. Denkbar ist jedoch auch, die Strukturelemente 6 gleich groß in regelmäßigen Abständen anzuordnen.

Das Gefüge der dargestellten Strukturelemente 6, die mit der Reflexionsschicht 3 formschlüssig verbunden sind, entspricht lokal unterschiedlich geneigten Spiegelflächen. Die Strahlungsablenkung mittels spekularer Reflexion trägt zur Steigerung der Strahlungsauskopplung bei.

Ferner kann auf die Auskoppelschicht 4 eine Fensterschicht aufgebracht werden, die für die erzeugte Strahlung durchlässig ist. Die Fensterschicht enthält vorzugsweise ein Material, das einen Brechungsindex kleiner als das Material des strahlungsemittierenden Körpers 1 und größer als ein angrenzendes Medium, beispielsweise Luft, aufweist. Dadurch kann die Strahlungsauskopplung weiter verbessert werden.

Besonders bevorzugt enthält die Fensterschicht ein Epoxid, Epoxidharz, Silikon oder eine Mischung dieser Materialien. Diese Materialien wirken sich zusätzlich positiv auf die Alterungsbeständigkeit des strahlungsemittierenden Körpers 1 aus.

Bei dem in Figur 3 dargestellten strahlungsemittiereden Körper 1 umfasst die Schichtenfolge 55 die Halbleiter-Schichtenfolge 5 und eine zwischen der Halbleiter-Schichtenfolge 5 und der Reflexionsschicht 3 angeordnete Zwischenschicht 9. Diese ist für die auftreffende Strahlung durchlässig.

Durch die Zwischenschicht 9 kann die mechanische Stabilität des strahlungsemittierenden Körpers 1 verbessert und die elektrische Leitfähigkeit beeinflusst werden.

Um den strahlungsemittiereden Körper 1 rückseitig zu isolieren, kann die Zwischenschicht 9 ein dielektrisches Material, beispielsweise SiN oder SiO₂ enthalten.

Um einen rückseitigen elektrischen Kontakt zu ermöglichen, kann die Zwischenschicht 9 ein leitfähiges Metalloxid, beispielsweise ITO oder ZnO, enthalten.

Vorzugsweise wird die Zwischenschicht 9 formschlüssig, beispielsweise durch Aufsputtern oder CVD, auf eine strukturierte Oberfläche 12 der Halbleiter-Schichtenfolge 5 aufgebracht. Eine der Reflexionsschicht 3 zugewandte Oberfläche 15 der Zwischenschicht 9 bildet die Grenzfläche 10. Die Strukturelemente 6 der Oberfläche 15 beziehungsweise der Grenzfläche 10 kommen durch entsprechend geformte Elemente auf der Oberfläche 12 der Halbleiter-Schichtenfolge 5 zustande, so dass die Reflexionsschicht 3 wiederum mit zu den Strukturelementen inversen Elementen ausgebildet ist.

Die Strukturelemente 6 können eine Strukturgröße im Bereich der Wellenlänge der auftreffenden Strahlung aufweisen. Alternativ kann die Strukturgröße wesentlich größer sein als die Wellenlänge.

Bei einer weiteren Ausführungsform kann die Zwischenschicht 9 zumindest teilweise elektrisch leitend beziehungsweise isolierend ausgebildet sein.

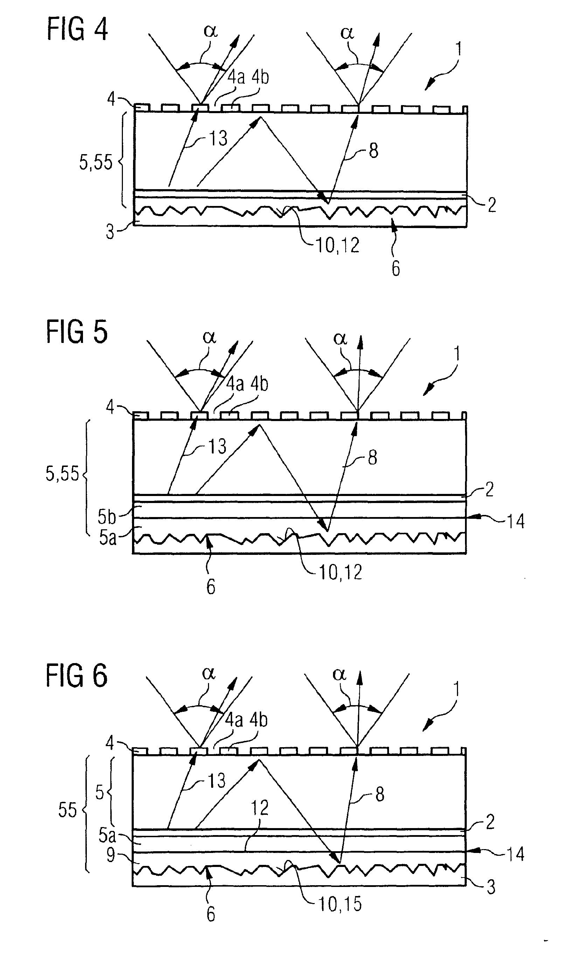

Bei dem in Figur 4 dargestellten strahlungsemittierenden Körper 1 ist die Auskoppelschicht 4 als photonischer Kristall ausgebildet. Der photonische Kristall weist Bereiche 4a mit einem ersten Brechungsindex und Bereiche 4b mit einem zweiten Brechungsindex auf. Vorzugsweise sind die Bereiche 4a als Vertiefungen in eine abschließende Schicht der Schichtenfolge 55 eingebracht. Die Vertiefungen können weiterhin mit einem Füllmaterial gefüllt sein, das einen von dem Halbleitermaterial der abschließenden Halbleiterschicht verschiedenen Brechungsindex aufweist.

Vorzugsweise sind die Bereiche 4a zylinderförmig ausgebildet. Aber auch jede andere Form ist denkbar. Die Bereiche 4a sind regelmäßig angeordnet, sodass sich aufgrund dieser Anordnung ein zweidimensionales Gitter ergibt.

Strahlung, die im aktiven Bereich 2 erzeugt wird, kann auf direktem Wege, wie der Strahl 13 veranschaulicht, in die Auskoppelschicht 4 gelangen und aus dem strahlungsemittierenden Körper 1 auskoppeln, wenn sie innerhalb eines unkritischen Winkels auf die Auskoppelschicht 4 auftrifft. Die aus dem strahlungsemittierenden Körper 1 austretende Strahlung bildet einen Strahlungskegel mit einem Öffnungswinkel α. Auf indirektem Wege kann die Strahlung, wie beispielsweise der Strahl 8 veranschaulicht, in die Auskoppelschicht 4 gelangen, wenn sie zuerst vom aktiven Bereich 2 in Richtung der Auskoppelschicht 4 emittiert und dort, weil sie unter einem kritischen Winkel auf die Auskoppelschicht 4 auftrifft, in die Schichtenfolge 5 zurückreflektiert wird. Die Strahlung kann dann an der Reflexionsschicht 3 reflektiert werden und aufgrund der strukturierten Grenzfläche 10 derart umgelenkt werden, dass sie unter einem unkritischen Winkel auf die Auskoppelschicht 4 auftrifft und folglich aus dem strahlungsemittierenden Körper 1 auskoppelt.

Auch der in Figur 5 dargestellte strahlungsemittierende Körper 1 weist wie der in Figur 4 dargestellte strahlungsemittierende Körper 1 eine als photonischer Kristall ausgebildete Auskoppelschicht 4 auf. Im Unterschied zu dem in Figur 4 dargestellten strahlungsemittierenden Körper 1 umfasst der in Figur 5 dargestellte strahlungsemittierende Körper 1 bevorzugterweise p-seitig einen Tunnelübergang 14 auf, welcher in die Schichtenfolge 55 integriert ist. Besonders bevorzugt enthält die Halbleiterschicht 5a, die eine erste Tunnelschicht bildet, ein hochdotiertes n-leitendes Halbleitermaterial, während die Halbleiterschicht 5b, die eine zweite Tunnelschicht bildet, ein hochdotiertes p-leitendes Halbleitermaterial aufweist. Vorteilhafterweise entfällt in diesem Ausführungsbeispiel die Kontaktausbildung auf einer p-leitenden Halbleiterschicht, die sich vergleichsweise schwierig gestalten kann. Da das p-leitende Halbleitermaterial eine relativ geringe Leitfähigkeit aufweist, hat die Kontaktausbildung auf der n-leitenden Halbleiterschicht 5a den Vorteil, dass die Einsatzspannung verringert ist.

Der in Figur 6 dargestellte strahlungsemittierende Körper 1 weist einen dem in Figur 5 dargestellten strahlungsemittierenden Körper 1 vergleichbaren rückseitigen, vorzugsweise p-seitigen, Kontakt auf. Denn auch hier ist zur Verbesserung der elektrischen Verbindung zwischen dem aktiven Bereich 2 und der Reflexionsschicht 3 ein Tunnelübergang 14 ausgebildet. Allerdings ist der Tunnelübergang 14 nicht in die Halbleiter-Schichtenfolge 5 integriert, sondern zwischen der Zwischenschicht 9 als einer ersten Tunnelschicht und einer an die Zwischenschicht 9 angrenzenden Halbleiterschicht 5a der Halbleiter-Schichtenfolge 5 als einer zweiten Tunnelschicht ausgebildet. Die Zwischenschicht 9 enthält insbesondere ein TCO, beispielsweise ITO, und kann nach der Herstellung der Halbleiter-Schichtenfolge 5 auf die Oberfläche 12 aufgebracht sein. Eine an die Reflexionsschicht 3 angrenzende Oberfläche 15 der Zwischenschicht 9, die die Grenzfläche 10 bildet, ist mit einer lateralen Strukturierung mit einer Mehrzahl von hervorstehenden Strukturelementen 6 versehen.

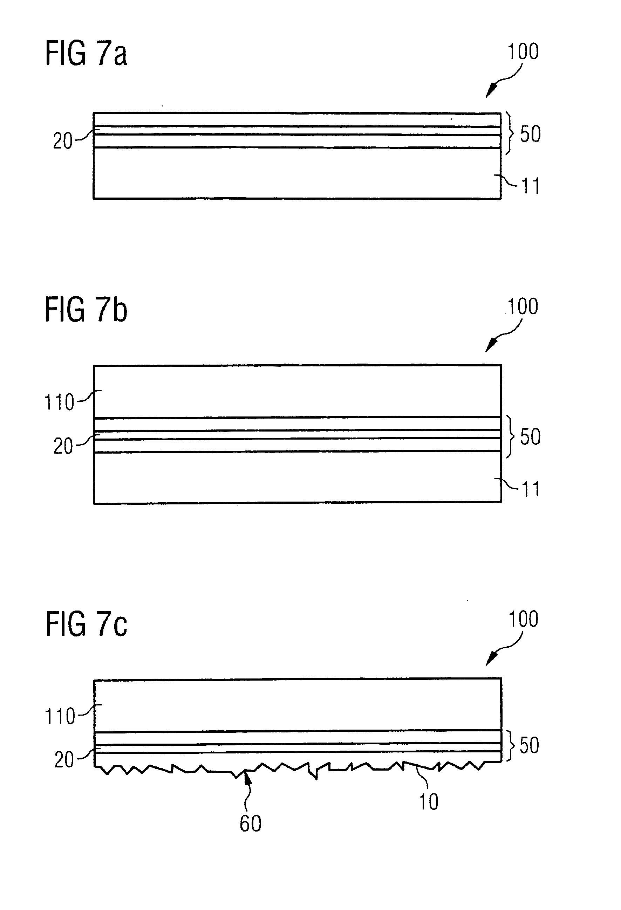

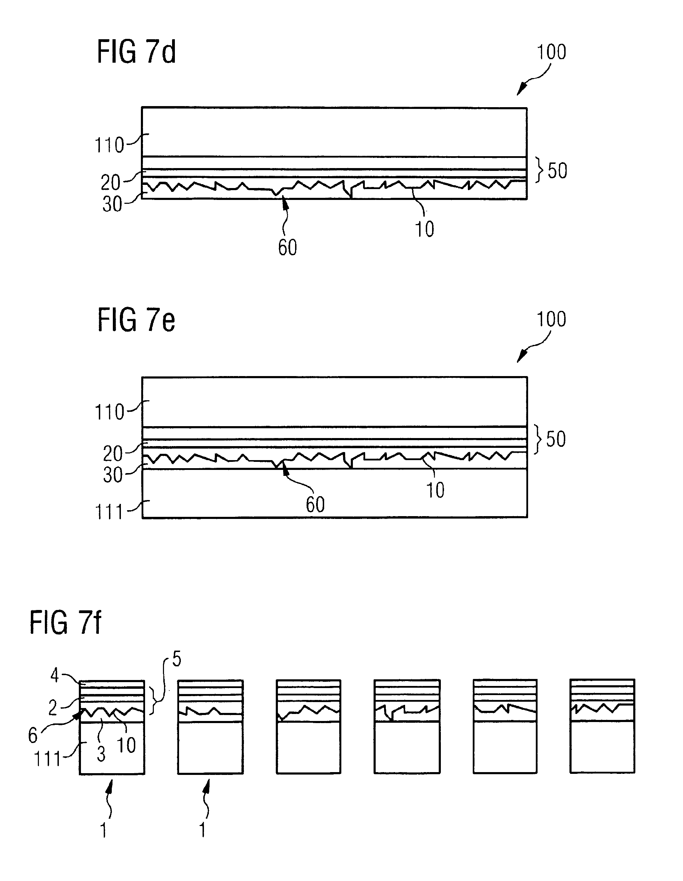

Bei dem in Figur 7 dargestellten Verfahren zur Herstellung eines strahlungsemittierenden Körpers wird zunächst (Figur 7a) auf einem Substrat 11 eine Halbleiter-Schichtenfolge 50 angeordnet. Der so gebildete Wafer 100 umfasst einen aktiven Bereich 20, der zur Erzeugung von Strahlung vorgesehen ist.

Vorzugsweise enthält die Halbleiter-Schichtenfolge 50 ein im Sinne der oben genannten Definition auf Phosphid- oder Nitrid-basierendes Verbindungshalbleitermaterial, insbesondere InGaAlP oder InGaN. Aber auch ein auf Arsenbasierendes Verbindungsmaterial, beispielsweise GaAlAs, ist denkbar.

Besonders bevorzugt wird die Halbleiter-Schichtenfolge 50 auf das Substrat 11 aufgewachsen. Hierbei enthält das Substrat 11 typischerweise ein Materialsystem, dessen Gitterkonstante an die Gitterkonstante des Materialsystems der Schichtenfolge 50 angepasst ist. Bei einem auf Nitrid-basierenden Verbindungshalbleiter ist beispielsweise ein Substrat geeignet, das Saphir oder SiC enthält.

Bei einem in Figur 7b dargestellten weiteren Herstellungsschritt wird auf einer dem Substrat 11 gegenüber liegenden Seite der Halbleiter-Schichtenfolge 50 ein Zwischenträger 110 aufgebracht. Der Zwischenträger 110 verstärkt die Halbleiter-Schichtenfolge 50 beim Ablösen des Substrats 11.

Wie in Figur 7c dargestellt, wird eine Grenzfläche 10 der Halbleiter-Schichtenfolge 50, von der das Substrat 11 abgelöst wurde, mit Strukturelementen 60 versehen. Vorzugsweise wird die Grenzfläche 10 mittels eines der bereits genannten Verfahren aufgeraut. Dadurch werden besonders bevorzugt Strukturelemente 60 ausgebildet, die auf der Grenzfläche 10 unregelmäßig angeordnet sind und unterschiedliche Strukturgrößen aufweisen. In Abhängigkeit vom jeweiligen Materialsystem kann die Strukturgröße entweder im Bereich der Wellenlänge der im späteren Betrieb relevanten Strahlung liegen oder wesentlich größer sein als diese.

In Figur 7d ist das Aufbringen einer Reflexionsschicht 30 auf die mit den Strukturelementen 60 versehene Grenzfläche 10 dargestellt. Vorzugsweise enthält die Reflexionsschicht 30 ein Metall, das beispielsweise durch Aufdampfen oder Aufsputtern auf die Grenzfläche 10 aufgebracht werden kann.

Bei einem in Figur 7e dargestellten Schritt wird der Wafer 100 mit einem Träger 111 verbunden. Nachfolgend kann der Zwischenträger 110 abgelöst werden.

Schließlich kann der Wafer 100 in eine Mehrzahl strahlungsemittierender Körper 1 vereinzelt werden (Figur 7f). Die Körper 1 weisen die Halbleiter-Schichtenfolge 5 mit dem aktiven Bereich 2, die Auskoppelschicht 4 und die dieser gegenüber liegende Reflexionsschicht 3 auf, wobei zwischen dem aktiven Bereich 2 und der Reflexionsschicht 3 die Strukturelemente 6 angeordnet sind.

Alternativ kann nach dem in Figur 7a dargestellten Herstellungsschritt eine von dem Substrat abgewandte Oberfläche der Halbleiter-Schichtenfolge mit Strukturelementen versehen werden. Anschließend wird auf der mit den Strukturelementen versehenen Seite der Träger angeordnet und das Substrat abgelöst. Der Wafer kann dann in eine Mehrzahl strahlungsemittierender Körper vereinzelt werden.

Diese Patentanmeldung beansprucht die Priorität der deutschen Patentanmeldung 102006017556.5, deren Offenbarungsgehalt hiermit durch Rückbezug aufgenommen wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Strahlungsemittierender Körper (1) umfassend
- eine Schichtenfolge (55), die einen aktiven Bereich (2) zur Erzeugung von elektromagnetischer Strahlung aufweist,
- eine auf einer ersten Seite der Schichtenfolge (55) angeordnete Auskoppelschicht (4) zur Auskopplung der erzeugten Strahlung,
- eine auf einer der ersten Seite gegenüberliegenden zweiten Seite angeordnete Reflexionsschicht (3) zur Reflexion der erzeugten Strahlung und
- eine der Reflexionsschicht (3) zugewandte Grenzfläche (10) der Schichtenfolge (55), die eine laterale Strukturierung mit einer Mehrzahl von hervorstehenden Strukturelementen (6) aufweist, wobei
die Reflexionsschicht (3) derart mit der Schichtenfolge (55) verbunden ist, dass die Reflexionsschicht (3) eine der Strukturierung der Grenzfläche (10) entsprechende Strukturierung aufweist.

2. Strahlungsemittierender Körper (1) nach Anspruch 1, wobei
die Schichtenfolge (55) eine Halbleiter-Schichtenfolge (5) umfasst.

3. Strahlungsemittierender Körper (1) nach einem der vorhergehenden Ansprüche, wobei
der strahlungsemittierende Körper (1) ein Dünnfilm-Halbleiterkörper ist.

4. Strahlungsemittierender Körper (1) nach einem der vorhergehenden Ansprüche, wobei
die Strukturelemente (6) eine Strukturgröße aufweisen, die größer ist als die Wellenlänge der erzeugten Strahlung.

5. Strahlungsemittierender Körper (1) nach einem der Ansprüche 1 bis 3, wobei
die Strukturelemente (6) eine Strukturgröße aufweisen, die etwa der Wellenlänge der erzeugten Strahlung entspricht.

6. Strahlungsemittierender Körper (1) nach einem der vorhergehenden Ansprüche, wobei
die Reflexionsschicht (3) ein Metall enthält oder als metallische Schicht ausgebildet ist.

7. Strahlungsemittierender Körper (1) nach Anspruch 6, wobei
die Reflexionsschicht (3) Au, Ag oder Al enthält.

8. Strahlungsemittierender Körper (1) nach einem der vorhergehenden Ansprüche, wobei
die Reflexionsschicht (3) unmittelbar auf die Schichtenfolge (55) aufgebracht ist.

9. Strahlungsemittierender Körper (1) nach einem der vorhergehenden Ansprüche, wobei
die Reflexionsschicht (3) formschlüssig mit der Schichtenfolge (55) verbunden ist.

10. Strahlungsemittierender Körper (1) nach Anspruch 2 oder einem der auf Anspruch 2 rückbezogenen Ansprüche, wobei
die Schichtenfolge (55) eine Zwischenschicht (9) aufweist, die zwischen der Halbleiter-Schichtenfolge (5) und der Reflexionsschicht (3) angeordnet ist.

11. Strahlungsemittierender Körper (1) nach Anspruch 10, wobei
die Zwischenschicht (9) für die erzeugte Strahlung durchlässig ist.

12. Strahlungsemittierender Körper (1) nach Anspruch 10 oder 11, wobei
die Zwischenschicht (9) ein dielektrisches Material enthält.

13. Strahlungsemittierender Körper (1) nach Anspruch 12, wobei
die Zwischenschicht (9) SiN oder SiO₂ enthält.

14. Strahlungsemittierender Körper (1) nach einem der Ansprüche 10 oder 11, wobei
die Zwischenschicht (9) ein elektrisch leitendes Material enthält.

15. Strahlungsemittierender Körper (1) nach Anspruch 14, wobei
die Zwischenschicht (9) ITO oder ZnO enthält.

16. Strahlungsemittierender Körper (1) nach einem der Ansprüche 10 bis 15, wobei
eine an die Zwischenschicht (9) angrenzende Oberfläche (12) der Halbleiter-Schichtenfolge (5) eben ausgebildet ist.

17. Strahlungsemittierender Körper (1) nach einem der vorhergehenden Ansprüche, wobei
die Grenzfläche (10) der Schichtenfolge (55) aufgeraut ist.

18. Strahlungsemittierender Körper (1) nach einem der Ansprüche 10 bis 15, wobei
eine an die Zwischenschicht (9) angrenzende Oberfläche (12) der Halbleiter-Schichtenfolge (5) eine Mehrzahl von Strukturelementen (6) aufweist.

19. Strahlungsemittierender Körper (1) nach einem der vorhergehenden Ansprüche, wobei
zwischen dem aktiven Bereich (2) und der Reflexionsschicht (3) ein Tunnelübergang (14) angeordnet ist.

20. Strahlungsemittierender Körper (1) nach einem der vorhergehenden Ansprüche, wobei
auf der Auskoppelschicht (4) eine für die erzeugte Strahlung durchlässige Fensterschicht (7) angeordnet ist.

21. Strahlungsemittierender Körper (1) nach Anspruch 20, wobei
die Fensterschicht (7) elektrisch leitend ist.

22. Strahlungsemittierender Körper (1) nach Anspruch 20 oder 21, wobei
die Fensterschicht (7) ein Material enthält, dessen Brechungsindex kleiner ist als der eines Materials des strahlungsemittierenden Körpers (1) und größer als der eines angrenzenden Mediums.

23. Strahlungsemittierender Körper (1) nach einem der vorhergehenden Ansprüche, wobei
die Auskoppelschicht (4) eine laterale Strukturierung aufweist.

24. Strahlungsemittierender Körper (1) nach Anspruch 23, wobei
die Auskoppelschicht (4) aufgeraut ist.

25. Strahlungsemittierender Körper (1) nach Anspruch 23, wobei
die Auskoppelschicht (4) ein photonischer Kristall ist.

26. Strahlungsemittierender Körper (1) nach einem der vorhergehenden Ansprüche, wobei
die Auskoppelschicht (4) ein Teil der Halbleiter-Schichtenfolge (5) ist.

27. Verfahren zur Herstellung eines strahlungsemittierenden Körpers (1) mit folgenden Schritten:
- Ausbilden einer Schichtenfolge (50) umfassend einen aktiven Bereich (20) zur Erzeugung von Strahlung auf einem Substrat (11),
- Ausbilden einer lateralen Strukturierung mit einer Mehrzahl von hervorstehenden Strukturelementen (60) auf einer Grenzfläche (10) der Schichtenfolge (50),
- Anordnen einer Reflexionsschicht (30) zur Reflexion der erzeugten Strahlung auf der die Strukturelemente (60) aufweisenden Grenzfläche (10), so dass die Reflexionsschicht (30) eine der Strukturierung der Grenzfläche (10) entsprechende Strukturierung aufweist.

28. Verfahren nach Anspruch 27, wobei
die Schichtenfolge eine Halbleiter-Schichtenfolge (50) umfasst.

29. Verfahren nach Anspruch 28, wobei
das Substrat (11) abgelöst wird.

30. Verfahren nach Anspruch 28 oder 29, wobei
zur Ausbildung der Grenzfläche (10) eine Oberfläche der Schichtenfolge oder der Halbleiter-Schichtenfolge (50) aufgeraut wird.

31. Verfahren nach Anspruch 30, wobei
die Oberfläche mittels natürlicher Lithographie strukturiert wird.

32. Verfahren nach Anspruch 30, wobei
die Oberfläche mittels nasschemischem Ätzen strukturiert wird.

33. Verfahren nach Anspruch 30, wobei
die Oberfläche mittels Photolithographie strukturiert wird.

34. Verfahren nach einem der Ansprüche 27 bis 33, wobei
die Reflexionsschicht (30) unmittelbar auf die Grenzfläche (10) aufgebracht wird.

35. Verfahren nach Anspruch 34, wobei
die Reflexionsschicht (30) auf die Grenzfläche (10) aufgesputtert wird.

36. Verfahren nach Anspruch 34, wobei
die Reflexionsschicht (30) auf die Grenzfläche (10) aufgedampft wird.

37. Verfahren nach Anspruch 34, wobei
die Reflexionsschicht (30) auf die Grenzfläche (10) mittels Galvanisierung aufgebracht wird.

38. Verfahren nach einem der Ansprüche 28 bis 37, wobei zwischen der Halbleiter-Schichtenfolge (50) und der Reflexionsschicht (30) eine Zwischenschicht ausgebildet wird.

39. Verfahren nach Anspruch 38, wobei
die Zwischenschicht mittels Aufsputtern auf die Halbleiter-Schichtenfolge aufgebracht wird.

40. Verfahren nach Anspruch 38, wobei
die Zwischenschicht mittels CVD auf die Halbleiter-Schichtenfolge aufgebracht wird.

41. Verfahren nach einem der Ansprüche 27 bis 40, wobei
eine Auskoppelschicht (4) mit einer lateralen Strukturierung versehen wird.
